Europäisches Patentamt

European Patent Office

Office européen des brevets

(11) Veröffentlichungsnummer: **0 262 731 B1**

# (12) EUROPÄISCHE PATENTSCHRIFT

(45) Veröffentlichungstag der Patentschrift: **16.12.92**

(21) Anmeldenummer: **87201821.3**

(22) Anmeldetag: **22.09.87**

(51) Int. Cl.⁵: **H03M 7/42**

(54) **Schaltungsanordnung zur Umcodierung eines Datensignales.**

(30) Priorität: **26.09.86 DE 3632682**

(43) Veröffentlichungstag der Anmeldung:
**06.04.88 Patentblatt  88/14**

(45) Bekanntmachung des Hinweises auf die
Patenterteilung:
**16.12.92 Patentblatt  92/51**

(84) Benannte Vertragsstaaten:
**DE FR GB IT SE**

(56) Entgegenhaltungen:
**DE-A- 3 510 901**
**FR-A- 2 541 836**
**GB-A- 2 167 219**
**US-A- 3 689 899**

(73) Patentinhaber: **Philips Patentverwaltung GmbH**
**Wendenstrasse 35 Postfach 10 51 49**
**W-2000 Hamburg 1(DE)**

(84) Benannte Vertragsstaaten:
**DE**

(73) Patentinhaber: **N.V. Philips' Gloeilampenfabrieken**
**Groenewoudseweg 1**
**NL-5621 BA Eindhoven(NL)**

(84) Benannte Vertragsstaaten:
**FR GB IT SE**

(72) Erfinder: **Lutz, Georg, Dipl.-Ing.**
**Scherleitenstrasse 17**
**W-8581 Heinersreuth(DE)**

(74) Vertreter: **Peuckert, Hermann, Dipl.-Ing. et al**
**Philips Patentverwaltung GmbH Wendenstrasse 35 Postfach 10 51 49**
**W-2000 Hamburg 1(DE)**

## Beschreibung

Die Erfindung betrifft eine Schaltungsanordnung zur Umcodierung eines Datensignales mit konstanter Bitrate und Codeworten unterschiedlicher Länge in ein Ausgangssignal aus Codeworten konstanter Länge aber variabler Bitrate unter Verwendung eines Pufferspeichers, bei der ein erster Codierer vorgesehen ist, der die Codeworte des Datensignales erkennt und sie in Codeworte gleicher Länge umcodiert und bei der diese Codeworte in den Pufferspeicher eingeschrieben werden, durch einen zweiten Codierer aus ihm ausgelesen und in Codeworte des Ausgangssignales umcodiert werden.

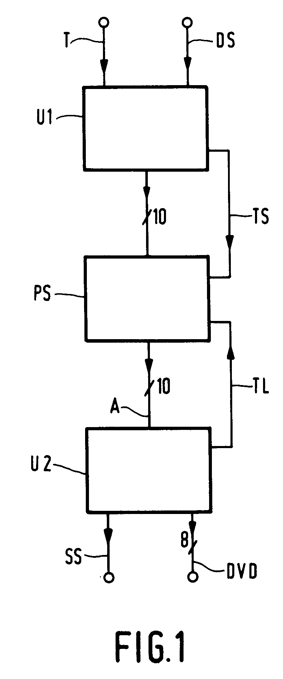

Eine solche Schaltungsanordnung ist in der deutschen Patentanmeldung DE-A1-3 510 901, veröffentlicht am 09.10.86, beschrieben. Sie wird z.B. zur Decodierung von empfangenen Videodaten und den zugehörigen Steuerworten verwendet, die als Codewortfolge aus Codeworten variabler Länge übertragen werden, um die Bitrate des Übertragungssignales möglichst gering zu halten. Die Fig. 1 zeigt ein Prinzipschaltbild der eingangs angegebenen Schaltungsanordnung.

Über Eingangsklemmen wird einem ersten Codierer U1 ein empfangenes Datensignal DS - bestehend aus Videodaten und Steuerworten - und der Bittakt T des Datensignales zugeführt. Die Bitgeschwindigkeit des Datensignales DS liegt bei 2 Mbit/s. Der Codierer U1, der nach der oben angegebenen deutschen Patentanmeldung aus einem schnellen Mikroprozessor besteht, erkennt die ungleichlangen Worte im empfangenen Datensignal DS und codiert sie in 10-Bit-Codeworte um. Diese 10-Bit-Codeworte werden mit Hilfe eines Schreibtaktes TS in einen Pufferspeicher PS eingeschrieben. Die Vorschrift zur Umcodierung des Datensignales in die 10-Bit-Codeworte ist derart gewählt, daß an den 10-Bit-Codeworten nur noch geringfügige Veränderungen vorgenommen werden müssen, um die Codeworte des Datensignales in der endgültig benötigten Form zu erhalten. Eine Trennung von Videodaten und Steuerworten wird an dieser Stelle nicht vorgenommen.

Die Codeworte des Datensignales erhalten ihre endgültige Form durch einen zweiten Codierer U2, der mit Hilfe eines Lesetaktes TL die 10-Bit-Codeworte aus dem Pufferspeicher PS ausliest und sie in Codeworte des Ausgangssignals umcodiert.

Die Codeworte des Ausgangssignals liegen in paralleler Form an den Ausgangsklemmen des zweiten Codierers U2 an. Die Trennung von Videodaten und Steuerworten ist in der Weise vorgenommen, daß an acht Ausgangsklemmen die decodierten Videodaten DVD abnehmbar sind, während an den restlichen Ausgangsklemmen die decodierten Steuerworte SS anliegen. Diese Art der Trennung ist eine Folge der Umcodierungstabelle, die in dem als EPROM ausgestalteten zweiten Codierer U2 abgelegt ist.

Wie oben schon erwähnt, ist in der zitierten Patentanmeldung der erste Codierer U1 als Mikroprozessor ausgeführt, dessen Funktion im wesentlichen durch die im zugehörigen Programmspeicher abgespeicherten Programme festgelegt ist.

Der Erfindung liegt die Aufgabe zugrunde, einen aus Einzelbausteinen aufgebauten Codierer anzugeben, der bei einer Schaltungsanordnung der eingangs genannten Art die Funktion des ersten Codierers übernimmt.

Diese Aufgabe wird dadurch gelöst, daß der erste Codierer ein Schieberegister enthält, durch das das Datensignal mit seinem Bittakt geschoben wird, daß Eingänge eines ersten Speichers und Eingänge eines Vergleichers mit Parallelausgängen des Schieberegisters verbunden sind, daß ein Ausgang des ersten Speichers mit einem Freigabeeingang des Vergleichers verbunden ist und der Vergleicher dann freigegeben wird, wenn ein eindeutiges Erkennen der Codeworte des Datensignales mit Hilfe des ersten Speichers nicht möglich ist, daß Ausgangsdaten des ersten Speichers und des Vergleichers in einen Zwischenspeicher übernommen werden und an Eingänge eines zweiten Speichers angelegt sind, daß die Taktimpulse zur übernahme der Ausgangsdaten des ersten Speichers und des Vergleichers in den Zwischenspeicher an einem Ausgang des zweiten Speichers anliegen, daß ein weiterer Ausgang des zweiten Speichers Rücksetzimpulse für ein mit dem Bittakt getakteten Zähler abgibt, dessen Stufen mit weiteren Eingängen des zweitenp Speichers verbunden sind und daß der zweite Speicher an weiteren Ausgängen Steuersignale abgibt, mit denen Logiken veranlaßt werden, Codeworte gleicher Länge an den Pufferspeicher abzugeben.

Vorteilhafte Ausgestaltungen sind in den Unteransprüchen angegeben. Anhand der Figuren soll ein Ausführungsbeispiel der Erfindung näher erläutert werden.

Fig. 1    zeigt das Blockschaltbild der eingangs angegebenen Schaltungsanordnung und

Fig. 2    ein Ausführungsbeispiel für den ersten Codierer bei einer Schaltungsanordnung der eingangs angegebenen Art.

Das Blockschaltbild nach Fig. 1 ist in den Ausführungen zum Stande der Technik schon erläutert worden. Der aus Einzelbausteinen bestehende Aufbau des ersten Codierers U1 nach Fig. 1, der Codeworte unterschiedlicher Länge in Codeworte gleicher Länge umcodiert, hängt davon ab, wie die Codeworte unterschiedlicher Länge des umzucodierenden Datensignales im Detail aufgebaut sind.

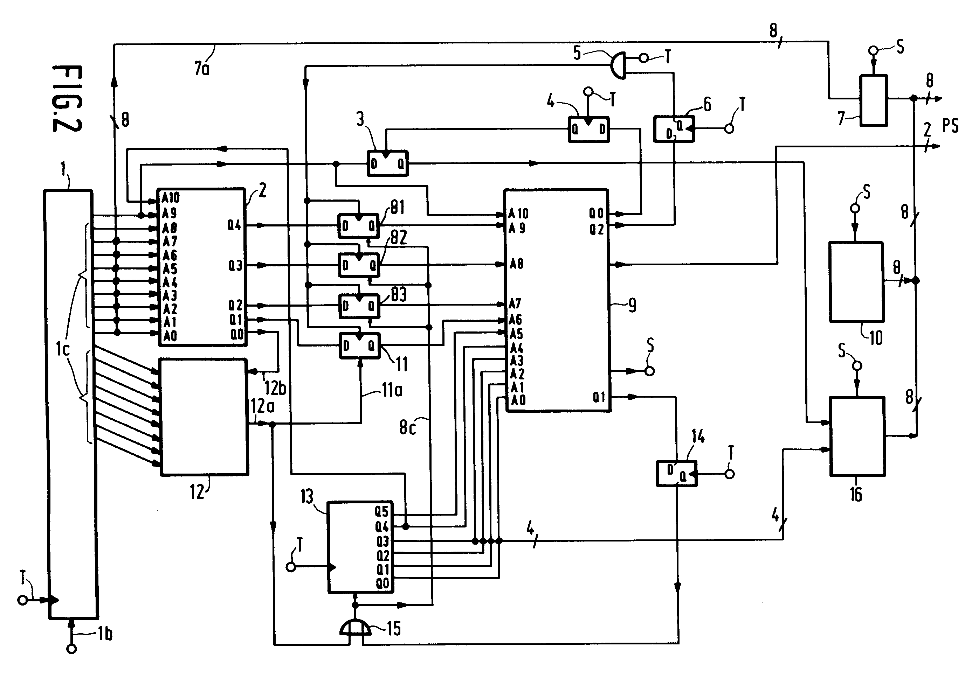

Bei dem Codierer nach Fig. 2 besteht das Datensignal aus einem Videosignal, das über eine Leitung 1b durch ein Schieberegister 1 mit einem 2 MHz-Takt T geschoben wird und folgende Codeworte enthält:

16 Line-Start-Codeworte (LSC-Worte) zu je 20 Bit;
2 Field-Start-Codeworte (FSC-Worte) zu je 28 Bit;
ein PCM-Kennwort (PCK-Wort), durch das dem Empfänger zu verstehen gegeben wird, daß die folgende Zeile des Videosignales in PCM-Codeworten übertragen wird;
224 PCM-Codeworte zu je 8 Bit;
256 Adressworte (ADR-Worte) zu je 8 Bit;
ein 4-Bit-Codewort, das sogenannte End-Of-Cluster-Codewort (EOC-Wort);
einem Farbcodewort (C-Codewort) aus 8 Bits, das dem Empfänger zu verstehen gibt, daß die nun folgenden Angaben die Farbkomponenten des Videosignales betreffen;
16 Codeworte variabler Länge (VLC-Worte), von denen die ersten acht - bei zunehmender Anzahl von Bits - nur führende Nullen mit einer Eins am Ende enthalten und die restlichen acht - ebenfalls bei steigender Bitzahl - mit einer binären Eins beginnen und enden, sonst aber nur Nullen enthalten.

Die Verteilung von Nullen und Einsen innerhalb der aufgezählten Codeworte ist so gewählt, daß beginnend mit dem ersten Bit eines Codewortes 17 weitere Bits ausreichen, um entscheiden zu können, welche zulässigen Codeworte die insgesamt 18 Bits enthalten oder welche zulässigen Codeworte die 18 Bits umfassen. Daher enthält das Schieberegister 1 18 Parallelausgänge 1c, von denen die - in Datenflußrichtung gesehenen - zehn hinteren Ausgänge an die Eingänge A0 bis A9 eines EPROMs 2 und die acht vorderen an die Eingänge eines Vergleichers 12 geführt sind. Der Vergleicher 12 wird nur gelegentlich freigegeben, nämlich dann, wenn die Bitkombination an den Eingängen A0 bis A7 des EPROMs 2 ein LSC-Wort oder ein FSC-Wort vermuten läßt. Das Freigabesignal wird von einem Ausgang Q0 des EPROMs 2 über eine Leitung 12b an den Freigabeeingang des Vergleichers 12 geleitet. Das Signal am Ausgang Q0 des EPROMs 2 wird - ebenso wie die Signale an den Ausgängen Q1, Q2, Q3 und Q4 des EPROMs 2 - von den Signalen an den elf Eingängen A0 bis A10 des EPROMs 2 gesteuert. Der Zusammenhang zwischen Eingangs- und Ausgangssignalen ist durch die im EPROM 2 abgelegte Tabelle festgelegt.

Ist der Vergleicher 12 freigegeben, werden weitere acht Bit des Videosignales zur Bestätigung oder Widerlegung der oben ausgesprochenen Vermutung herangezogen. Der Vergleicher 12 vergleicht dann die weiteren acht Bit mit einer für LSC- oder FSC-Worte charakteristischen Bitkombination. Vom Ausgang des Vergleichs hängt die dann folgende Zustandsänderung des Codierers nach Fig. 2 ab, wie weiter unten näher erläutert.

Bei den sich nun anschließenden Erläuterungen wird grundsätzlich davon ausgegangen, daß sich der Codierer im eingeschwungenen Zustand befindet, was insbesondere heißt, daß eine Abfrage der Ausgänge Q1 bis Q4 des EPROMs 2 dann erfolgt, wenn an seinem Eingang A7 das erste Bit eines Codeworts steht. Abfragen in diesem Zusammenhang bedeutet die Übernahme der Ausgangsvariablen an den Ausgängen Q1 bis Q4 an die Q-Ausgänge von vier Flip-Flops 81, 82, 83 und 11.

Gesteuert wird die Übernahme von einem zweiten EPROM 9, das an einem Ausgang Q2 Taktimpulse für die Flip-Flops 81, 82, 83 und 11 abgibt. Die am Ausgang Q2 des EPROMs 9 anliegenden Taktimpulse werden durch ein Flip-Flop 6 und ein Gatter 5 verzögert und auf den Bittakt T synchronisiert. Nach der Übernahme der Ausgangsvariablen an den Ausgängen Q1 bis Q4 an die Q-Ausgänge der Flip-Flops 81, 82, 83 und 11 liegen diese Variablen auch an den zugeordneten Eingängen A6 bis A9 des EPROMs 9 an. Das EPROM 9 steuert nun - aufgrund der in ihm abgelegten Tabelle - in Abhängigkeit auch von den Variablen an seinen weiteren Eingängen A0 bis A5 und A10 den Lauf eines Zählers 13 über Rücksetzimpulse an einem Ausgang Q1. Die Rücksetzimpulse werden durch ein Flip-Flop 14 auf den Takt T synchronisiert und über ein ODER-Gatter 15 an den Rücksetzeingang des Zählers 13 geleitet. Unter der Voraussetzung, daß das EPROM 9 aufgrund der Information an seinen Eingängen A6 bis A9 eindeutig erkennt, zu welchem Codewort das am Eingang A7 des EPROMs 2 anliegende Bit gehört, ist auch die Länge dieses Codeworts erkannt. Der Rücksetzimpuls vom EPROM 9 an den Zähler 13 erfolgt nun erst dann, wenn der Zähler 13 um so viele Zähltakte weiter gelaufen ist, wie das erkannte Codewort Binärstellen enthält. Um das EPROM 9 über den Stand des Zählers 13 zu informieren, sind die Stufen Q0 bis Q5 des Zählers 13 mit den Eingängen A0 bis A5 des EPROMs 9 verbunden. Erhält der Zähler 13 einen Rücksetzimpuls, so werden mit dem gleichen Impuls über eine Leitung 8c auch die Flip-Flops 81, 82 und 83 zurückgesetzt. Bei Vorliegen der obengenannten Voraussetzung steht nach dem Rücksetzen des Zählers 13 und der Flip-Flops 81, 82 und 83 das erste Bit des nächsten Codewortes am Eingang A7 des EPROMs 2 an; in diesem Augenblick wird auch vom EPROM 9 ein neuer Taktimpuls an die Flip-Flops 81, 82, 83 und 11 übertragen, so daß sich dann - bei gleicher Voraussetzunng - die oben geschilderten Vorgänge wiederholen.

Der Codierer nach Fig. 2 codiert Codeworte des Videosignales in 10-Bit-Codeworte um. Die umcodierten Codeworte werden in paralleler Form an einen durch PS angedeuteten Pufferspeicher weitergegeben. Verlaufen die Vorgänge wie oben geschildert, so handelt es sich bei den anliegenden Codeworten z.B. um VLC-Worte, die eindeutig durch den Wert ihres führenden Bits und durch die Anzahl ihrer Binärstellen kennzeichenbar sind. Die Anzahl ihrer Bits läßt sich am Stand des Zählers 13 erkennen, den er vor einem Rücksetzimpuls erreicht hat. Da die untersten vier Stufen des Zählers zur Angabe der Länge aller VLC-Worte ausreichen, sind sie mit vier Eingängen einer Logik 16 verbunden, der zusätzlich mit Flip-Flops 3 und 4 der Wert des führenden Bits eines VLC-Wortes zugeführt wird. Die Logik 16 wird von Steuersignalen S des EPROMs 9 gesteuert; sie wird unter anderem veranlaßt, zwei aufeinanderfolgende VLC-Worte, bei denen drei Bit zur Kennzeichnung ihrer Länge ausreichen, zu einem einzigen 8-Bit-Codewort zusammenzufassen und abzugeben. Ist diese Zusammenfassung nicht möglich, gibt die Logik 16 dennoch ein 8-Bit-Codewort aus, das zusammen mit zwei zusätzlichen parallelen Bits des EPROMs 9 dem Pufferspeicher PS zugeführt wird.

Erkennt das EPROM 9, daß an den Eingängen A0 bis A7 des EPROMs 1 ein PCM-Codewort oder ein Adressenwort anliegt, so wird über das Steuersignal S eine weitere Logik 7 angesteuert, deren Eingänge über Leitungen 7a mit den Eingängen A0 bis A7 des EPROMs 1 parallel geschaltet sind. Die Logik 7 gibt dann das 8-Bit-Codewort an ihren Ausgang weiter, von wo es zusammen mit zwei weiteren Bits des EPROMs 9 zum Pufferspeicher PS gelangt.

Liegt an den Eingängen des EPROMs 2 ein LSC-Wort oder ein FSC-Wort an, so fällt nach Freigabe des Vergleichers 12 der Vergleich mit dem Inhalt der vorderen acht Stufen des Schieberegisters 1 positiv aus. Über Teilleitungen 12a, 11a, über das Gatter 15 und über die Leitung 8c werden dann der Zähler 13 und die Flip-Flops 11, 81, 82 und 83 zurückgesetzt; darauf wird mindestens 16 Schiebetakte gewartet - sie sind gleichzeitig Zähltakte - bis die noch nicht geprüften Bits eines LSC- oder FSC-Wortes an Eingängen des EPROMs 2 anliegen. Mit der nun zur Verfügung stehenden Information und der Aussage, daß der Zähler 13 den Stand 16 erreicht hat - diese Aussage ist an der binären Eins in der vierten Stufe des Zählers 13 erkennbar, deren Ausgang Q4 mit dem Eingang A10 des EPROMs 2 verbunden ist - ist das EPROM 9 in der Lage, zwischen LSC- und FSC-Worten zu unterscheiden. Über das Steuersignal S wird sodann eine dritte Logik 10 angesteuert, die ein 8-Bit-Codewort erzeugt, das die gleiche Information wie ein LSC- oder ein FSC-Wort enthält, und dieses zusammen mit zwei Zusatzbits an den Pufferspeicher PS weitergibt.

**Patentansprüche**

1. Schaltungsanordnung zur Umcodierung eines Datensignales mit konstanter Bitrate und Codeworten unterschiedlicher Länge in ein Ausgangsignal aus Codeworten konstanter Länge aber variabler Bitrate unter Verwendung eines Pufferspeichers, bei der ein erster Codierer vorgesehen ist, der die Codeworte des Datensignales erkennt und sie in Codeworte gleicher Länge umcodiert und bei der diese Codeworte in den Pufferspeicher eingeschrieben werden, durch einen zweiten Codierer aus ihm ausgelesen und in Codeworte des Ausgangssignales umcodiert werden,
dadurch gekennzeichnet,
daß der erste Codierer (U1) ein Schieberegister (1) enthält, durch das das Datensignal mit seinem Bittakt (T) geschoben wird, daß Eingänge (A0 bis A9) eines ersten Speichers (2) und Eingänge eines Vergleichers (12) mit Parallelausgängen (1c) des Schieberegisters (1) verbunden sind, daß ein Ausgang (Q0) des ersten Speichers (2) mit einem Freigabeeingang des Vergleichers (12) verbunden ist und der Vergleicher (12) dann freigegeben wird, wenn ein eindeutiges Erkennen der Codeworte des Datensignales mit Hilfe des ersten Speichers (2) nicht möglich ist, daß Ausgangsdaten des Speichers (2) und des Vergleichers (12) in einen Zwischenspeicher (11, 81, 82, 83) übernommen werden und an Eingänge eines zweiten Speichers (9) angelegt sind, daß die Taktimpulse zur Übernahme der Ausgangsdaten des ersten Speichers (2) und des Vergleichers (12) in den Zwischenspeicher (11, 81, 82, 83) an einem Ausgang (Q2) des zweiten Speichers (9) anliegen, daß ein weiterer Ausgang des zweiten Speichers (9) Rücksetzimpulse für einen mit dem Bittakt (T) getakteten Zähler (13) abgibt, dessen Stufen mit weiteren Eingängen des zweiten Speichers (9) verbunden sind, und daß der zweite Speicher (9) an weiteren Ausgängen Steuersignale (S) abgibt, mit denen Logiken (7, 10, 16) veranlaßt werden, Codeworte gleicher Länge an den Pufferspeicher (PS) abzugeben.

2. Schaltungsanordnung nach Anspruch 1, dadurch gekennzeichnet, daß es sich bei dem Zwischenspeicher um Flip-Flops (11, 81, 82, 83) handelt, die von Übernahmeimpulsen des zweiten Speichers (9) getaktet werden.

3. Schaltungsanordnung nach Anspruch 1 oder 2, dadurch gekennzeichnet, daß bei Vorliegen eines PCM-Codewortes oder eines gleichartigen Codewortes im Schieberegister (1) dieses Codewort parallel über eine Logik (7), die von den Steuersignalen (S) des zweiten Speichers (9) aufgesteuert wird, direkt an den Pufferspeicher (PS) weitergeleitet wird.

4. Schaltungsanordnung nach Anspruch 1, 2 oder 3, dadurch gekennzeichnet, daß Eingänge einer weiteren Logik (16) mit Stufen des Zählers (13) verbunden sind und die weitere Logik (16) - gesteuert von den Steuersignalen (S) des zweiten Speichers (9) - den Zählerstand und zusätzliche Informationen in Codeworte gleicher Länge umsetzt und zum Pufferspeicher (PS) weiterleitet.

## Claims

1. A circuit arrangement for converting a data signal having a constant bit rate and code words of different length into an output signal consisting of code words of constant length but with a variable bit rate while using a buffer memory, in which arrangement a first encoder is provided which recognizes the code words of the data signal and converts them into code words of equal length and in which these code words are written in the buffer memory, read out from this memory by a second encoder and converted into code words of the output signal, characterized in that the first encoder (U1) comprises a shift register (1) through which the data signal with its bit clock (T) is shifted, in that inputs (A0 to A9) of a first memory (2) and inputs of a comparator (12) are connected to parallel outputs (1c) of the shift register (1), in that an output (Q0) of the first memory (2) is connected to an enable input of the comparator (12) which is enabled when a uniform recognition of the code words of the data signal by means of the first memory (2) is not possible, in that output data of the memory (2) and of the comparator (12) are transferred to an intermediate memory (11, 81, 82, 83) and are applied to inputs of a second memory (9), in that the clock pulses for transferring the output data of the first memory (2) and of the comparator (12) to the intermediate memory (11, 81, 82, 83) are present at an output (Q2) of the second memory (9), in that a further output of the second memory (9) supplies reset pulses for a bit-lock (T) controlled counter (13) whose stages are connected to further inputs of the second memory (9) and in that the second memory (9) supplies control signals S from further outputs, said control signals initiating logic circuits (7, 10, 16) to apply code words of equal length to the buffer memory (PS).

2. A circuit arrangement as claimed in Claim 1, characterized in that the intermediate memories are flipflops (11, 81, 82, 83) which are clock-controlled by transfer pulses of the second memory (9).

3. A circuit arrangement as claimed in Claim 1 or 2, characterized in that in the presence of a PCM code word or a similar code word in the shift register (1) this code word is directly passed on to the buffer memory (PS), in parallel via a logic circuit (7) which is controlled by the control signals (S) of the second memory (9).

4. A circuit arrangement as claimed in Claim 1, 2 or 3, characterized in that inputs of a further logic circuit (16) are connected to stages of the counter (13) and in that the further logic circuit (16) - controlled by the control signals (S) of the second memory (9) converts the counter position and additional information into code words of equal length and passes them on to the buffer memory (PS).

## Revendications

1. Circuit pour transcoder, à l'aide d'une mémoire tampon, un signal de données qui présente une fréquence de bits constante ainsi que des mots de code de longueur différente, en un signal de sortie qui présente des mots de code de longueur constante, mais une fréquence de bits variable, circuit dans lequel est prévu un premier codeur qui reconnaît les mots de code du signal de données et les transcode en mots de code de longueur égale et dans lequel ces mots de code sont enregistrés dans la mémoire tampon, lus dans celle-ci par un deuxième codeur et transcodés en mots de code du signal de sortie, caractérisé en ce que le premier codeur (U1) comprend un registre à décalage (1) à travers lequel le signal de données est décalé au rythme de son horloge de bits (T), en ce que des entrées (A0 à A9) d'une première mémoire (2) et des entrées d'un comparateur (12) sont reliées à des sorties parallèles (1c) du registre à décalage (1), en ce qu'une sortie (Q0) de la première mémoire (2) est reliée à une entrée de déblocage du comparateur (12) et en ce que le comparateur (12) est débloqué lorsqu'il est impossible de reconnaître de manière univoque les mots de code du signal de données à l'aide de la première mémoire (2), en ce que des données de sortie de la mémoire (2) et du comparateur (12) sont transférées dans une mémoire intermédiaire (11, 81, 82, 83) et sont présentes aux entrées d'une deuxième mémoire (9), en ce que les impulsions d'horloge pour le transfert des données de sortie de la première mémoire (2) et du comparateur (12) vers la mémoire intermédiaire (11, 82, 82, 83), sont disponibles sur une sortie (Q2) de la deuxième mémoire (9), en ce qu'une autre sortie de la deuxième mémoire (9) fournit des impulsions de remise pour un compteur rythmé par l'horloge de bits (T), compteur dont les étages sont reliés à d'autres entrées de la deuxième mémoire (9), et en ce que la deuxième mémoire (9) délivre sur d'autres sorties des signaux de commande (S) par lesquels des circuits logiques (7, 10, 16) sont amenés à fournir des mots de code de longueur égale à la mémoire tampon (PS).

2. Circuit selon la revendication 1, caractérisé en ce qu'il s'agit, dans le cas de la mémoire intermédiaire, de bascules (11, 81, 82, 83) rythmées par des impulsions de transfert de la deuxième mémoire (9).

3. Circuit selon la revendication 1 ou 2, caractérisé en ce que, si un mot de code PCM ou un mot de code semblable est présent dans le registre à décalage (1), ce mot de code est retransmis directement à la mémoire tampon (PS) en parallèle par l'intermédiaire d'un circuit logique (7) commandé par les signaux de commande (S) de la deuxième mémoire (9).

4. Circuit selon la revendication 1,2 ou 3, caractérisé en ce que des entrées d'un autre circuit logique (16) sont reliées à des étages du compteur (13) et en ce que l'autre circuit logique (16) - commandé par les signaux de commande (S) de la deuxième mémoire (9) - convertit la position du compteur ainsi que des informations supplémentaires en mots de code de longueur égale et les retransmet à la mémoire tampon (PS).

FIG.1

FIG.2